# EUROPEAN PATENT SPECIFICATION

(11) **EP 2 922 089 B1**
(45) Date of publication and mention of the grant of the patent: **18.03.2020**
(21) Application number: 14859326.2
(22) Date of filing: 22.04.2014
(51) Int. Cl.: H01L 27/32, H01L 27/12, H01L 51/00, B32B 37/04

(54) **MANUFACTURING METHOD FOR AND SUBSTRATE STRUCTURE OF FLEXIBLE DISPLAY**
HERSTELLUNGSVERFAHREN UND SUBSTRATSTRUKTUR FÜR EINE FLEXIBLE ANZEIGE
STRUCTURE DE SUBSTRAT D'ÉCRAN FLEXIBLE ET SON PROCÉDÉ DE FABRICATION

(30) Priority: 06.12.2013 CN 201310654927
(43) Date of publication of application: 23.09.2015
(73) Proprietor: BOE Technology Group Co., Ltd., Beijing 100015 (CN)
(72) Inventor: CHENG, Hongfei, Beijing 100176 (CN); ZHANG, Yuxin, Beijing 100176 (CN)
(74) Representative: Cohausz & Florack
(86) International application number: PCT/CN2014/075955
(87) International publication number: WO 2015/081654

(56) References cited:
- CN-A- 102 760 846
- CN-A- 103 337 478
- CN-A- 103 413 775
- CN-A- 103 681 486
- US-A1- 2002 132 449
- US-A1- 2012 228 617
- US-A1- 2013 089 954
- US-A1- 2014 042 399

## Description

### Field of the Invention

The present invention relates to the field of display technology, and particularly relates to a manufacturing method of a flexible display device and a substrate structure used in the process of manufacturing the flexible display device.

### Background of the Invention

Flexible display technology has developed rapidly in recent years, thus bringing great progress of flexible display devices in the aspects of screen size and display quality. Both cathode ray tube (simply referred to as CRT) displays on the verge of disappearance and liquid crystal displays (simply referred to as LCD) as the current mainstream essentially belong to traditional rigid display devices. Compared with the traditional rigid display devices, the flexible display devices have a variety of advantages, such as high impact resistance, strong shock resistance, light weight, small volume, increased portability and the like.

At present, the flexible display devices may be mainly divided into three types: electronic paper (flexible electrophoretic display), flexible organic light-emitting diodes (simply referred to as OLED) and flexible LCDs. The preparation method thereof is generally an adhering and lower removing method, in which a flexible substrate is adhered on a hard substrate through an adhesive layer, then display elements are prepared on the flexible substrate, and the back surface (i.e., a surface with no adhesive layer adhered) of the hard substrate is scanned by using a high-energy laser beam to age the adhesive layer after the display elements are prepared, so that the flexible substrate is stripped from the hard substrate to obtain a flexible display device. These are done to precisely fix a position of the flexible substrate and keep the flatness of the flexible substrate in the manufacturing process of the flexible display, so as to prevent malposition when preparing the display elements subsequently.

However, in the above-mentioned manufacturing method of the flexible display, the stripping uniformity is poor, and large-scale stripping could not be achieved.

US patent application US 2013/089954 A1 discloses a method of fabricating an electronic device having a flexible device, which is fabricated using a support substrate by Joule-heating induced film separation (JIFS). The method of fabricating an electronic device having a flexible device includes providing a support substrate, coating a conductive layer on one surface of the support substrate, forming a plastic substrate on the other surface of the support substrate, forming one or more thin-film transistors (TFTs) on the plastic substrate, forming an electronic device electrically connected to any one of the TFTs, and separating the plastic substrate from the conductive layer by generating Joule-heating through application of an electric field to the conductive layer.

US patent application US 2002/132449 A1 discloses a method for manufacturing a semiconductor film including a step of preparing a first member including a semiconductor substrate, a semiconductor layer, and a separation layer provided between the semiconductor substrate and the semiconductor layer, a step of bonding or attracting a second member which is hardly heated by induction heating, onto the semiconductor layer of the first member, and a step of separating the semiconductor layer from the semiconductor substrate at the separation layer by heating the semiconductor substrate by induction heating.

US patent application US 2012/228617 A1 discloses a method for manufacturing a flexible display device including forming a heat generator on a carrier substrate, forming a flexible substrate on the heat generator, forming a thin film transistor on the flexible substrate, forming a light emitting element connected to the thin film transistor, and separating the flexible substrate from the heat generator by application of heat to the flexible substrate, the application of heat including generation of heat by the heat generator.

### Summary of the Invention

Embodiments of the present invention provide a manufacturing method of a flexible display device and a substrate structure, which may be used for uniformly stripping a flexible substrate of the flexible display device from a bearing substrate.

To fulfill the above-mentioned object, the embodiments of the present invention adopt the following technical solutions.

According to one aspect of the present invention, a manufacturing method of a flexible display device is provided in accordance with claim 1.

Further optionally, the insulated heat conduction layer is a ceramic layer or a glass layer.

Optionally, the area of the electromagnetic heater is larger than or equal to the area of the bearing substrate, and the bearing substrate is entirely arranged above the electromagnetic heater.

Optionally, the adhesive includes at least one of silicone adhesive, polyimide adhesive and acrylate adhesive.

Optionally, the step of forming the display elements on the surface of the flexible substrate opposite to the surface which is adhered to the adhesive layer includes: forming at least an anode, an organic material functional layer and a cathode on the surface of the flexible substrate opposite to the surface which is adhered to the adhesive layer, wherein the organic material functional layer is located between the anode and the cathode.

Further, a thin film transistor is further formed on the surface of the flexible substrate opposite to the surface which is adhered to the adhesive layer, wherein a drain electrode of the thin film transistor is electrically connected with the anode.

Optionally, the step of forming the display elements on the surface of the flexible substrate opposite to the surface which is adhered to the adhesive layer includes: forming at least a thin film transistor and a pixel electrode electrically connected with a drain electrode of the thin film transistor on the surface of the flexible substrate opposite to the surface which is adhered to the adhesive layer.

Optionally, the step of forming the display elements on the surface of the flexible substrate opposite to the surface which is adhered to the adhesive layer includes: forming at least a color layer and a black matrix on the surface of the flexible substrate opposite to the surface which is adhered to the adhesive layer, wherein the color layer includes at least a red photoresistor, a green photoresistor and a blue photoresistor.

Further, the method further includes: further forming a common electrode on the surface of the flexible substrate opposite to the surface which is adhered to the adhesive layer.

Optionally, the method further includes: further forming an electrophoretic display unit on the surface of the flexible substrate opposite to the surface which is adhered to the adhesive layer.

According to another aspect of the present invention, a substrate structure is further provided in accordance with claim 11.

In the manufacturing method of the flexible display device and the substrate structure provided by the embodiments of the present invention, the electromagnetic heater is electrified to generate an alternating magnetic field. The metal plate of the bearing substrate located above the electromagnetic heater cuts alternating magnetic field lines so as to enable the metal plate to generate alternating current (i.e., eddy current). The eddy current drives metal atoms in the metal plate to move irregularly at high speed, so that the metal atoms collide and chafe against each other to generate heat energy. The heat energy is applied on the adhesive layer, and in this way, the adhesive in the adhesive layer is aged and the viscidity thereof is degraded. As a result, the flexible substrate is stripped from the bearing substrate. In the method provided by the embodiments of the present invention, the entire metal plate will generate the heat energy, and the heat energy conversion rate of the metal plate is high. Therefore, the converted heat energy may be uniformly applied to the entire adhesive layer, so that the flexible substrate can be uniformly stripped from the bearing substrate, and thus the method is suitable for manufacturing large-scale flexible display devices.

### Brief Description of the Drawings

To illustrate technical solutions in the embodiments of the present invention or in the prior art more clearly, a brief introduction on the accompanying drawings which are used in the description of the embodiments or the prior art is given below. Apparently, the accompanying drawings described below are merely some of the embodiments of the present invention, based on which drawings of other implementations may be obtained by those of ordinary skill in the art without any creative effort.
Fig. 1 is a flow chart of a manufacturing method of a flexible display device provided by an embodiment of the present invention;
Fig. 2a is a schematic diagram of sequentially forming an adhesive layer and a flexible substrate on a bearing substrate consisting of a metal plate;
Fig. 2b is a schematic diagram of sequentially forming an adhesive layer and a flexible substrate on a bearing substrate consisting of a metal plate and an insulated heat conduction layer provided as part of an embodiment of the present invention;
Fig. 3a is a schematic diagram of forming display elements on the flexible substrate shown in Fig. 2a;
Fig. 3b is a schematic diagram of forming display elements on the flexible substrate shown in Fig. 2b;
Fig. 4a is a schematic diagram of a substrate structure provided in the embodiment shown in Fig. 3a;
Fig. 4b is a schematic diagram of a substrate structure of the present invention provided in the embodiment shown in Fig. 3b;
Fig. 5 is a schematic diagram of stripping a flexible substrate from a bearing substrate according to a method provided by an embodiment of the present invention;
Fig. 6 is a schematic diagram of a structure of a flexible array display device obtained after forming a passive OLED on a bearing substrate according to a method provided by an embodiment of the present invention;
Fig. 7 is a schematic diagram of a structure of a flexible array display device obtained after forming an active OLED on a bearing substrate according to a method provided by an embodiment of the present invention;
Fig. 8a is a first schematic diagram of a structure of a flexible array display device obtained after forming an LCD on a bearing substrate according to a method provided by an embodiment of the present invention;
Fig. 8b is a second schematic diagram of a structure of a flexible array display device obtained after forming an LCD on a bearing substrate according to a method provided by an embodiment of the present invention;
Fig. 9 is a schematic diagram of a structure of a flexible color filter display device obtained after forming an LCD on a bearing substrate according to a method provided by an embodiment of the present invention.

### Reference numerals:

10 bearing substrate; 101 metal plate; 102 insulated heat conduction layer; 20 adhesive layer; 30 flexible substrate; 40 display element; 401 anode; 402 cathode; 403 organic material functional layer; 404 thin film transistor; 405 pixel electrode; 406 common electrode; 4071 red photoresistor; 4072 green photoresistor; 4073 blue photoresistor; 408 black matrix; 50 electromagnetic heater; 60 pixel isolation layer.

### Detailed Description of the Embodiments

A clear and complete description of technical solutions in the embodiments of the present invention will be given below in combination with the accompanying drawings in the embodiments of the present invention.

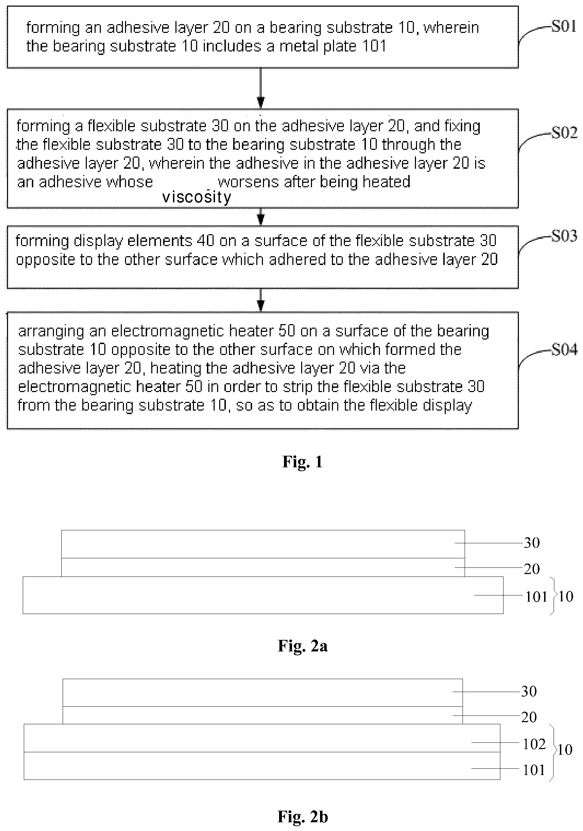

An embodiment of the present invention provides a manufacturing method of a flexible display device, as shown in Fig. 1, including the following steps.

S01: as shown in Figs. 2a and 2b, an adhesive layer 20 is formed on a bearing substrate 10.

Here, the bearing substrate 10 includes at least a metal plate 101, and the metal plate 101 may be, for example, an iron plate, a steel plate or other substrates made of metals with good thermal conductivity.

S02: as shown in Figs. 2a and 2b, a flexible substrate 30 is formed on the adhesive layer 20, and the flexible substrate 30 is fixed to the bearing substrate 10 through the adhesive layer 20.

Here, the adhesive in the adhesive layer 20 is an adhesive whose viscosity is degraded after being heated. For example, the adhesive may include at least one of silicone adhesive, polyimide adhesive and acrylate adhesive.

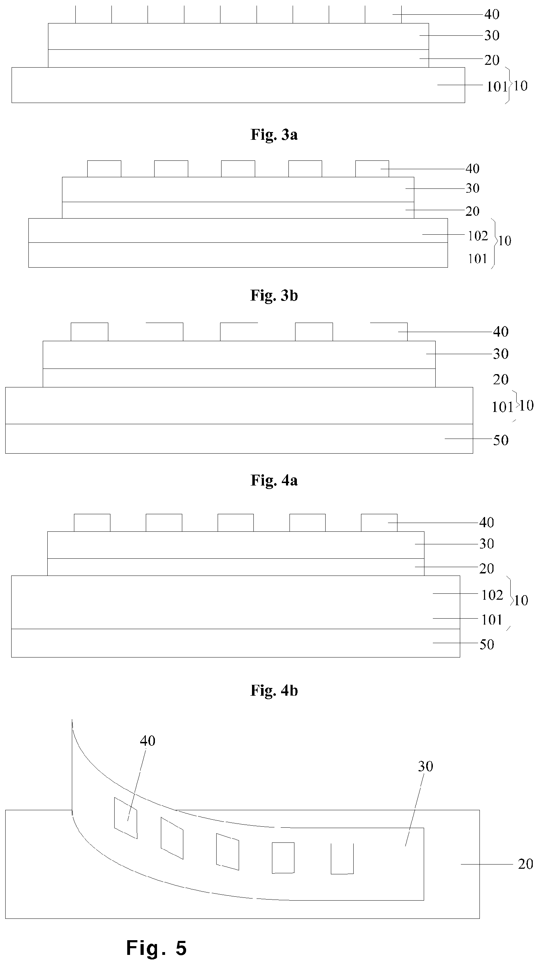

S03: as shown in Figs. 3a and 3b, display elements 40 are formed on a surface of the flexible substrate 30 opposite to the surface which is adhered to the adhesive layer 20.

S04: as shown in Figs. 4a and 4b, an electromagnetic heater 50 is arranged on a surface of the bearing substrate 10 opposite to the surface on which is formed the adhesive layer 20. Namely, the electromagnetic heater 50 is arranged beneath the bearing substrate 10, and it is preferable to ensure a close contact between the bearing substrate 10 and the electromagnetic heater 50 beneath the same. The adhesive layer 20 is heated by the electromagnetic heater 50 arranged beneath the bearing substrate 10, and as shown in Fig. 5, the flexible substrate 30 is stripped from the bearing substrate 10 (not shown in Fig. 5 due to being blocked by the adhesive layer 20), so that the flexible display is obtained.

In addition, an embodiment of the present invention provides a substrate structure as shown in Fig. 4b, wherein the substrate structure includes: a bearing substrate; an adhesive layer formed on the bearing substrate; and an electromagnetic heater arranged on a surface of the bearing substrate opposite to the other surface on which formed the adhesive layer. Wherein the adhesive layer is used for fixing the flexible substrate to the bearing substrate in the manufacturing process of the flexible display device, the adhesive in the adhesive layer is an adhesive whose viscosity is degraded after being heated. Moreover, the bearing substrate includes at least a metal plate.

Herein, the principle of stripping the flexible substrate 30 from the bearing substrate 10 in the way of heating the adhesive layer 20 through the electromagnetic heater 50 is as follows: the electromagnetic heater 50 is electrified to generate an alternating magnetic field; when the bearing substrate 10 including the metal plate 101 is located on the electromagnetic heater 50, the metal plate 101 cuts alternating magnetic field lines to generate alternating current (i.e., eddy current); the eddy current drives metal atoms in the metal plate 101 to move irregularly at high speed, so that the metal atoms collide and chafe against each other to generate heat energy; and due to the high heat energy conversion rate of the metal plate 101, the converted heat energy can be applied to the adhesive layer 20 located on the metal plate 101, in order to heat the adhesive layer 20, and thus to worsen the viscidity of the adhesive in the adhesive layer 20; in this way the flexible substrate 30 is stripped from the bearing substrate 10.

It should be noted that, firstly, the display element 40 in the embodiment of the present invention refers to a structure which is indispensable for displaying and formed by layers of patterns.

For example, when the flexible display is an LCD array display device, for one minimal display unit of the LCD array display, the display element 40 includes at least a thin film transistor, a pixel electrode and the like; when the flexible display is an LCD color filter display device, for one minimal display unit of the LCD color filter display, the display element 40 includes a red or green or blue photoresistor, a black matrix, and the like; when the flexible display is an OLED array display device, for one minimal display unit of the OLED array display device, the display element 40 includes at least a cathode, an anode and a light-emitting layer.

Of course, in addition, the display element 40 may further include some necessary pattern layers, such as a protection layer, or may further include some pattern layers which are added for improving the display effect or remedying some defects. Therefore, in the embodiment of the present invention, the display element 40 may be understood as multiple layers of patterns arranged on the flexible substrate 30 for one minimal display unit of the flexible display, and the flexible display may include multiple display elements 40.

Secondly, the bearing substrate 10 is a substrate with composite structure composed of at least two layers. The entire bearing substrate 10 should be a hard substrate and have good flatness.

In addition, according to the stripping principle described above, when the bearing substrate 10 includes at least two layers, the other layers excluding the metal plate 101 are made of a material with excellent thermal conductivity.

Thirdly, the thickness of the bearing substrate 10 is not limited; when the bearing substrate 10 includes at least two layers, a ratio between the thicknesses of the metal plate 101 and the other layers excluding the metal plate 101 is not limited either, as long as the heat generated by the metal plate 101 can be applied to the adhesive layer 20 to heat the adhesive layer 20, and further to strip the flexible substrate 30 from the bearing substrate 10.

Fourthly, in order to better strip the entire flexible substrate 30 from the bearing substrate 10, preferably, the area of the electromagnetic heater 50 should be larger than or equal to the area of the bearing substrate 10, and the entire bearing substrate 10 is completely arranged on the electromagnetic heater 50.

In addition, the internal structure of the electromagnetic heater 50 is not limited, and the electromagnetic heater may include an electronic circuit board capable of generating an alternating magnetic field.

In the manufacturing method of the flexible display and the substrate structure provided by the embodiments of the present invention, the electromagnetic heater 50 is electrified to generate an alternating magnetic field. The metal plate 101 of the bearing substrate 10 located on the electromagnetic heater 50 cuts alternating magnetic field lines to generate alternating current (i.e., eddy current) in the metal plate 101. The eddy current drives metal atoms in the metal plate 101 to move irregularly at high speed, so that the metal atoms collide and chafe against each other to generate heat energy. The heat energy is applied to the adhesive layer 20 to age the adhesive in the adhesive layer 20 and worsen the viscidity of the adhesive. Thus the flexible substrate 30 is stripped from the bearing substrate 10. In the method provided by the embodiment of the present invention, since the entire metal plate 101 may generate the heat energy, and the heat energy conversion rate of the metal plate 101 is high, the converted heat energy may be uniformly applied to the entire adhesive layer 20, so as to uniformly strip the flexible substrate 30 from the bearing substrate 10, and thus the method is suitable for manufacturing large-scale flexible displays. Not forming part of the present invention, as shown in Figs. 2a, 3a and 4a, the bearing substrate 10 merely includes one layer of metal plate 101, that is, the metal plate 101 forms the bearing substrate 10.

According to the present invention, as shown in Figs. 2b, 3b and 4b, the bearing substrate 10 includes the metal plate 101 and an insulated heat conduction layer 102 arranged on the metal plate 101, wherein the adhesive layer 20 is formed on the insulated heat conduction layer 102.

Further, the insulated heat conduction layer 102 may be a ceramic layer made of a ceramic material, or a glass layer.

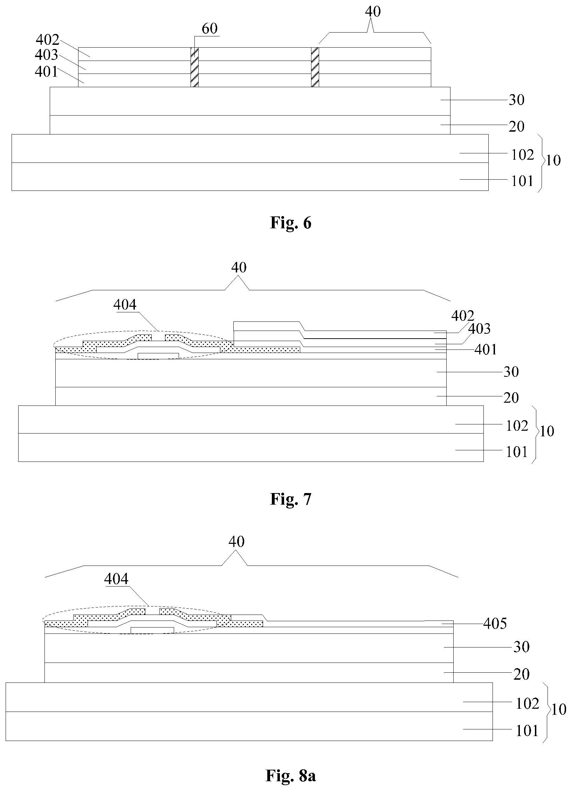

Based on the above descriptions, the step of forming the display elements 40 on a surface of the flexible substrate 30 opposite to the other surface which adhered to the adhesive layer 20 may specifically includes the following several cases:
In the first case, as shown in Fig. 6, when the flexible display device to be manufactured is a passive OLED array display device, an anode 401, an organic material functional layer 403 and a cathode 402 are sequentially formed on the surface of the flexible substrate 30 opposite to the other surface which is adhered with the adhesive layer 20, wherein the organic material functional layer 403 is located between the anode 401 and the cathode 402; the organic material functional layer 403 may include at least an electron transport layer, a light-emitting layer and a hole transport layer. The light-emitting layer is located between the electron transport layer and the hole transport layer, and the hole transport layer is located between the anode 401 and the light-emitting layer. In order to improve the efficiency of injecting electrons and holes into the light-emitting layer, preferably, the organic material functional layer 403 may further include an electron injection layer arranged between the cathode 402 and the electron transport layer, and a hole injection layer arranged between the anode 401 and the hole transport layer. That is, the anode 401, the five layers of the hole injection layer, the hole transport layer, the light-emitting layer, the electron transport layer, the electron injection layer (the five layers from the hole injection layer to the electron injection layer form the organic material functional layer 403) and the cathode 402 are sequentially formed on the surface of the flexible substrate 30 opposite to the other surface which adhered to the adhesive layer 20.

Here, any one anode 401, one cathode 402 corresponding to the anode 401 and the organic material functional layer 403 located between the anode 401 and the cathode 402 form one display element 40. In addition, as shown in Fig. 6, a pixel isolation layer 60 may be arranged between any two adjacent display elements 40 to isolate the adjacent display elements 40.

In the second case, as shown in Fig. 7, when the flexible display device to be manufactured is an active OLED array display device, a thin film transistor 404, an anode 401, an organic material functional layer 403 and a cathode 402 are sequentially formed on the surface of the flexible substrate 30 opposite to the other surface which adhered to the adhesive layer 20, wherein the organic material functional layer 403 is located between the anode 401 and the cathode 402; the thin film transistor 404 includes a gate electrode, a gate insulation layer, an active layer, a source electrode and a drain electrode, and the drain electrode is electrically connected with the anode 401.

Here, any one thin film transistor 404, the anode 401 electrically connected with the drain electrode of the thin film transistor 404, one cathode 402 corresponding to the anode 401 and the organic material functional layer 403 located between the anode 401 and the cathode 402 form one display element 40. Of course, the pixel isolation layer 60 may be arranged between any two adjacent display elements 40 to isolate the adjacent display elements 40.

It should be noted that, for the first and second cases, the sequence of forming the anode 401, the organic material functional layer 403 and the cathode 402 described in Figs. 6 and 7 is as follows: the anode 401 is firstly formed, then the organic material functional layer 403 is formed, and further the cathode 402 is formed, however, the sequence of forming the anode 401 and the cathode 402 is not limited in the present invention. That is to say, the anode 401 may be firstly formed, then the organic material functional layer 403 is formed, and further the cathode 402 is formed; alternatively, the cathode 402 may be firstly formed, then the organic material functional layer 403 is formed, and further the anode 401 is formed. Regardless of the sequence of forming the anode 401 and the cathode 402, the organic material functional layer 403 must be located between the anode 401 and the cathode 402.

In addition, after the display elements 40 are formed, through the use of the electromagnetic heater 50, the above-mentioned passive or active OLED array display device may be firstly stripped from the bearing substrate 10 and then packaged by a packaging material; alternatively, after the display elements 40 are formed, package is directly performed, and then through the use of the electromagnetic heater 50, the packaged passive or active OLED array display device is stripped from the bearing substrate 10.

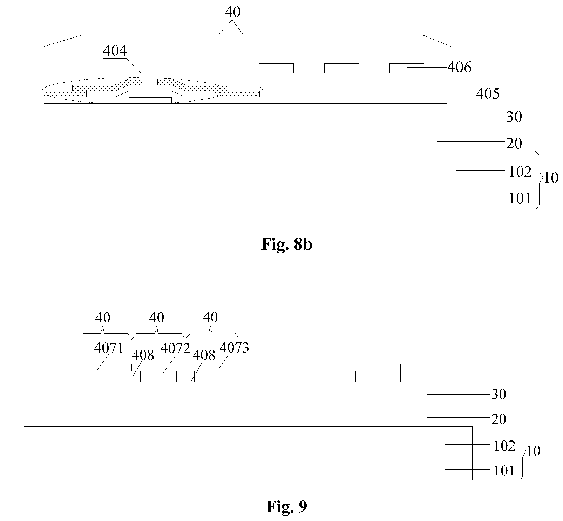

In the third case, as shown in Fig. 8a, when the flexible display to be manufactured is an LCD array display, a thin film transistor 404 and a pixel electrode 405 electrically connected with a drain electrode of the thin film transistor 404 are formed on the surface of the flexible substrate 30 opposite to the other surface which adhered to the adhesive layer 20. Of course, as shown in Fig. 8b, a common electrode 406 may also be additionally formed.

Here, any one thin film transistor 404 and the pixel electrode 405 electrically connected with the drain electrode of the thin film transistor 404 form one display element 40. When the LCD array display device further includes the common electrode 406, any one thin film transistor 404, the pixel electrode 405 electrically connected with the drain electrode of the thin film transistor 404 and the common electrode 406 corresponding to the pixel electrode 405 form one display element 40.

In the fourth case, as shown in Fig. 9, when the flexible display device to be manufactured is an LCD color filter display device, a color layer and a black matrix 408 are formed on the surface of the flexible substrate 30 opposite to the other surface which adhered to the adhesive layer 20; of course, a common electrode 406 may also be additionally formed. The color layer includes a red photoresistor 4071, a green photoresistor 4072 and a blue photoresistor 4073, and may further include a white photoresistor.

Here, the photoresistor of any color and the black matrix 408 surrounding the same form one display element 40.

It should be noted that, for the third and fourth cases, after the display elements 40 are formed, the LCD array display and the LCD color filter display may be respectively stripped from the bearing substrate 10 through the electromagnetic heater 50, and then cell-aligning processing is performed on the LCD array display device and the LCD color filter display device; alternatively, after the display elements 40 are formed, the cell-aligning process may be directly performed, and then the liquid crystal display device formed after the cell-aligning process is stripped from the bearing substrate 10 through the electromagnetic heater 50.

In addition, an electrophoretic display unit may also be formed on the surface of the flexible substrate 30 opposite to the other surface which adhered to the adhesive layer 20and is specifically set according to actual conditions, and will not be repeatedly described herein.

Based on the above descriptions, those skilled in the art should understand that, all the accompanying drawings in the embodiments of the present invention are schematic diagrams briefly illustrating the preparation process of the flexible display and the substrate structure, and are merely used for clearly describing the structures related to the invention which is defined by the appended claims.

## Claims

1. A manufacturing method of a flexible display device, comprising:
forming an adhesive layer on a bearing substrate (10), the bearing substrate (10) comprising at least a metal plate (101);
forming a flexible substrate (30) on the adhesive layer (20), and fixing the flexible substrate (30) to the bearing substrate (10) through the adhesive layer (20);
forming display elements on a surface of the flexible substrate (30) opposite to the surface which is adhered to the adhesive layer (20); and
arranging an electromagnetic heater (50) on a surface of the bearing substrate (10), opposite to the surface on which is formed the adhesive layer (20), wherein the electromagnetic heater (50) is electrified to generate an alternating magnetic field which heats the metal plate (101) thereby heating the adhesive layer (20) via the electromagnetic heater (50) to strip the flexible substrate (30) from the bearing substrate (10), so as to obtain the flexible display device;
wherein the adhesive of the adhesive layer (20) is an adhesive whose viscosity is degraded after the adhesive is heated, and
wherein the bearing substrate (10) further comprises an insulated heat conduction layer (102) arranged on the metal plate (101), wherein the insulated heat conduction layer (102) is an insulating layer which conducts heat; and the adhesive layer (20) is formed on the insulated heat conduction layer (102).

2. The manufacturing method of claim 1, wherein the insulated heat conduction layer (102) is a ceramic layer or a glass layer.

3. The manufacturing method of claim 1, wherein the area of the electromagnetic heater (50) is larger than or equal to the area of the bearing substrate (10), and the bearing substrate (10) is entirely arranged above the electromagnetic heater (50).

4. The manufacturing method of any one of claims 1 to 3, wherein the adhesive comprises at least one of silicone adhesive, polyimide adhesive and acrylate adhesive.

5. The manufacturing method of claim 1, wherein,
the step of forming the display elements on the surface of the flexible substrate (30) opposite to the surface which is adhered to the adhesive layer (20), comprises:
forming at least an anode (410), an organic material functional layer (403) and a cathode (402) on the surface of the flexible substrate (30) opposite to the surface which is adhered to the adhesive layer (20), wherein the organic material functional layer (403) is located between the anode (401) and the cathode (402).

6. The manufacturing method of claim 5, wherein a thin film transistor (404) is further formed on the surface of the flexible substrate (30) opposite to the surface which is adhered to the adhesive layer (20), and a drain electrode of the thin film transistor (404) is electrically connected with the anode (401).

7. The manufacturing method of claim 1, wherein,
the step of forming the display elements on the surface of the flexible substrate (30) opposite to the surface which is adhered to the adhesive layer (20) comprises:
forming at least a thin film transistor (404) and a pixel electrode (405) electrically connected with a drain electrode of the thin film transistor (404) on the surface of the flexible substrate (30) opposite to the surface which is adhered to the adhesive layer (20).

8. The manufacturing method of claim 1, wherein the step of forming the display elements on the surface of the flexible substrate (30) opposite to the surface which is adhered to the adhesive layer (20) comprises:
forming at least a color layer and a black matrix on the surface of the flexible substrate (30) opposite to the surface which is adhered to the adhesive layer (20),
wherein the color layer comprises at least a red photoresistor (4071), a green photoresistor (4072) and a blue photoresistor (4073).

9. The manufacturing method of claim 7 or 8, further comprising: further forming a common electrode (406) on the surface of the flexible substrate (30) opposite to the surface which is adhered to the adhesive layer (20).

10. The manufacturing method of claim 1, further comprising: further forming an electrophoretic display unit on the surface of the flexible substrate (30) opposite to the surface which is adhered to the adhesive layer (20).

11. A system comprising a substrate structure, used for the manufacturing process of claim 1, the substrate structure comprising:
a bearing substrate (10);
an adhesive layer (20) formed on the bearing substrate (10); and wherein the system comprises
an electromagnetic heater (50) arranged at a surface of the bearing substrate (10) opposite to the surface on which is formed the adhesive layer (20), wherein the electromagnetic heater (50) is capable of generating an alternating magnetic field when being electrified,
wherein the flexible substrate (30) is fixed to the bearing substrate (10) through the adhesive layer (20), and the adhesive of the adhesive layer (20) is an adhesive whose viscosity is degraded after the adhesive is heated,
wherein the bearing substrate (10) comprises at least a metal plate (101) capable of being heated by the alternating magnetic field generated by the electromagnetic heater (50) and
wherein the bearing substrate (10) further comprises an insulated heat conduction layer (102) arranged on the metal plate (101), wherein the insulated heat conduction layer (102) is an insulating layer which conducts heat; and the adhesive layer (20) is formed on the insulated heat conduction layer (102), and wherein the insulated heat conduction layer (102) is a ceramic layer or a glass layer.

12. The system of claim 11, wherein the area of the electromagnetic heater (50) is larger than or equal to the area of the bearing substrate (10), and the bearing substrate (10) is entirely arranged above the electromagnetic heater (50).

13. The system of any one of claims 11 to 12, wherein the adhesive comprises at least one of silicone adhesive, polyimide adhesive and acrylate adhesive.

## Patentansprüche

1. Herstellungsverfahren einer flexiblen Anzeigevorrichtung, umfassend:
Bilden einer Klebstoffschicht auf einem Trägersubstrat (10), wobei das Trägersubstrat (10) mindestens eine Metallplatte (101) aufweist;
Bilden eines flexiblen Substrats (30) auf der Klebstoffschicht (20), und Befestigen des flexiblen Substrats (30) an dem Trägersubstrat (10) durch die Klebstoffschicht (20);
Bilden von Anzeigeelementen auf einer Fläche des flexiblen Substrats (30), die der Fläche gegenüberliegt, die an der Klebstoffschicht (20) haftet; und
Anordnen einer elektromagnetischen Heizvorrichtung (50) auf einer Fläche des Trägersubstrats (10), die der Fläche gegenüberliegt, auf der die Klebstoffschicht (20) gebildet ist, wobei die
elektromagnetische Heizvorrichtung (50) elektrisch betrieben wird, um ein magnetisches Wechselfeld zu erzeugen, das die Metallplatte (101) erwärmt, so dass die Klebstoffschicht (20) dadurch über die elektromagnetische Heizvorrichtung (50) erwärmt wird, um das flexible Substrat (30) von dem Trägersubstrat (10) abzustreifen, um die flexible Anzeigevorrichtung zu gewinnen;
wobei der Klebstoff der Klebstoffschicht (20) ein Klebstoff ist, dessen Viskosität vermindert ist, nachdem der Klebstoff erwärmt ist, und
wobei das Trägersubstrat (10) ferner eine isolierte Wärmeleitungsschicht (102) aufweist, die auf der Metallplatte (101) angeordnet wird, wobei die isolierte Wärmeleitungsschicht (102) eine Isolierschicht ist, die Wärme leitet; und die Klebstoffschicht (20) auf der isolierten Wärmeleitungsschicht (102) gebildet wird.

2. Herstellungsverfahren nach Anspruch 1, wobei die isolierte Wärmeleitungsschicht (102) eine Keramikschicht oder eine Glasschicht ist.

3. Herstellungsverfahren nach Anspruch 1, wobei die Fläche der elektromagnetischen Heizvorrichtung (50) größer oder gleich der Fläche des Trägersubstrats (10) ist und das Trägersubstrat (10) vollständig oberhalb der elektromagnetischen Heizvorrichtung (50) angeordnet wird.

4. Herstellungsverfahren nach einem der Ansprüche 1 bis 3, wobei der Klebstoff mindestens eines von einem Silikonklebstoff, Polyimidklebstoff und Acrylatklebstoff umfasst.

5. Herstellungsverfahren nach Anspruch 1, wobei der Schritt des Bildens der Anzeigeelemente auf der Fläche des flexiblen Substrats (30), die der Fläche gegenüberliegt, die an der Klebstoffschicht (20) haftet, umfasst:
Bilden mindestens einer Anode (410), einer Funktionsschicht (403) aus einem organischem Material und einer Kathode (402) auf der Fläche des flexiblen Substrats (30), die der Fläche gegenüberliegt, die an der Klebstoffschicht (20) haftet, wobei die Funktionsschicht (403) aus dem organischem Material zwischen der Anode (401) und der Kathode (402) angeordnet wird.

6. Herstellungsverfahren nach Anspruch 5, wobei ferner ein Dünnfilmtransistor (404) auf der Fläche des flexiblen Substrats (30), die der Fläche gegenüberliegt, die an der Klebstoffschicht (20) haftet, gebildet wird und eine Drain-Elektrode des Dünnfilmtransistors (404) mit der Anode (401) elektrisch verbunden wird.

7. Herstellungsverfahren nach Anspruch 1, wobei,
der Schritt des Bildens der Anzeigeelemente auf der Fläche des flexiblen Substrats (30), die der Fläche gegenüberliegt, die an der Klebstoffschicht (20) haftet, umfasst:
Bilden mindestens eines Dünnfilmtransistors (404) und einer Pixelelektrode (405), die elektrisch mit einer Drain-Elektrode des Dünnfilmtransistors (404) verbunden ist, auf der Fläche des flexiblen Substrats (30), die der Fläche gegenüberliegt, die an der Klebstoffschicht (20) haftet.

8. Herstellungsverfahren nach Anspruch 1, wobei der Schritt des Bildens der Anzeigeelemente auf der Fläche des flexiblen Substrats (30), die der Fläche gegenüberliegt, die an der Klebstoffschicht (20) haftet, umfasst:
Bilden mindestens einer Farbschicht und einer schwarzen Matrix auf der Fläche des flexiblen Substrats (30), die der Fläche gegenüberliegt, die an der Klebstoffschicht (20) haftet,
wobei die Farbschicht mindestens einen Rot-Fotowiderstand (4071), einen Grün-Fotowiderstand (4072) und einen Blau-Fotowiderstand (4073) umfasst.

9. Herstellungsverfahren nach Anspruch 7 oder 8, ferner umfassend: Bilden einer gemeinsamen Elektrode (406) auf der Fläche des flexiblen Substrats (30), die der Fläche gegenüberliegt, die an der Klebstoffschicht (20) haftet.

10. Herstellungsverfahren nach Anspruch 1, ferner umfassend: zusätzliches Bilden einer elektrophoretischen Anzeigeeinheit auf der Fläche des flexiblen Substrats (30), die der Fläche gegenüberliegt, die an der Klebstoffschicht (20) haftet.

11. System mit einer Substratstruktur, das für das Herstellungsverfahren nach Anspruch 1 verwendet wird,
wobei die Substratstruktur aufweist:
ein Trägersubstrat (10);
eine Klebstoffschicht (20), die auf dem Trägersubstrat (10) gebildet ist; und wobei das System aufweist
eine elektromagnetische Heizvorrichtung (50), die an einer Fläche des Trägersubstrats (10) angeordnet ist, die der Fläche gegenüberliegt, auf der die Klebstoffschicht (20) gebildet ist, wobei die elektromagnetische Heizvorrichtung (50) in der Lage ist, ein magnetisches Wechselfeld zu erzeugen, wenn sie elektrisch betrieben wird,
wobei das flexible Substrat (30) an dem Trägersubstrat (10) durch die Klebstoffschicht (20) befestigt ist und der Klebstoff der Klebstoffschicht (20) ein Klebstoff ist, dessen Viskosität vermindert ist, nachdem der Klebstoff erwärmt ist,
wobei das Trägersubstrat (10) mindestens eine Metallplatte (101) aufweist, die durch das magnetische Wechselfeld erwärmt werden kann, das von der elektromagnetischen Heizvorrichtung (50) erzeugt ist, und
wobei das Trägersubstrat (10) ferner eine isolierte Wärmeleitungsschicht (102) aufweist, die auf der Metallplatte (101) angeordnet ist, wobei die isolierte Wärmeleitungsschicht (102) eine Isolierschicht ist, die Wärme leitet; und die Klebstoffschicht (20) auf der isolierten Wärmeleitungsschicht (102) gebildet ist, und wobei die isolierte Wärmeleitungsschicht (102) eine Keramikschicht oder eine Glasschicht ist.

12. System nach Anspruch 11, wobei die Fläche der elektromagnetischen Heizvorrichtung (50) größer oder gleich der Fläche des Trägersubstrats (10) ist und das Trägersubstrat (10) vollständig oberhalb der elektromagnetischen Heizvorrichtung (50) angeordnet ist.

13. System nach einem der Ansprüche 11 bis 12, wobei der Klebstoff mindestens eines von einem Silikonklebstoff, Polyimidklebstoff und Acrylatklebstoff umfasst.

## Revendications

1. Procédé de fabrication d'un dispositif d'affichage flexible, comprenant les étapes consistant à :
former une couche adhésive sur un substrat porteur (10), le substrat porteur (10) comprenant au moins une plaque métallique (101) ;
former un substrat flexible (30) sur la couche adhésive (20), et fixer le substrat flexible (30) au substrat porteur (10) au moyen de la couche adhésive (20) ;
former des éléments d'affichage sur une surface du substrat flexible (30) opposée à la surface qui a adhéré à la couche adhésive (20) ; et
disposer un élément chauffant électromagnétique (50) sur une surface du substrat porteur (10), opposée à l'autre surface sur laquelle est formée la couche adhésive (20), dans lequel l'élément chauffant électromagnétique (50) est électrifié pour générer un champ magnétique alternatif qui chauffe la plaque métallique (101) chauffant ainsi la couche adhésive (20) via l'élément chauffant électromagnétique (50) pour décaper le substrat flexible (30) du substrat porteur (10), de manière à obtenir le dispositif d'affichage flexible ;
dans lequel l'adhésif de la couche adhésive (20) est un adhésif dont la viscosité se dégrade après que l'adhésif a été chauffé, et
dans lequel le substrat porteur (10) comprend en outre une couche de conduction thermique isolée (102) disposée sur la plaque métallique (101), dans lequel la couche de conduction thermique isolée (102) est une couche isolante qui conduit la chaleur ; et la couche adhésive (20) est formée sur la couche de conduction thermique isolée (102).

2. Procédé de fabrication selon la revendication 1, dans lequel la couche de conduction thermique isolée (102) est une couche en céramique ou une couche en verre.

3. Procédé de fabrication selon la revendication 1, dans lequel la zone de l'élément chauffant électromagnétique (50) est d'une taille supérieure ou égale à la zone du substrat porteur (10), et le substrat porteur (10) est entièrement disposé au-dessus de l'élément chauffant électromagnétique (50).

4. Procédé de fabrication selon l'une quelconque des revendications 1 à 3, dans lequel l'adhésif comprend au moins un adhésif parmi de l'adhésif silicone, de l'adhésif polyimide et de l'adhésif acrylate.

5. Procédé de fabrication selon la revendication 1, dans lequel,
l'étape de formation des éléments d'affichage sur la surface du substrat flexible (30) opposée à la surface qui a adhéré à la couche adhésive (20), comprend l'étape consistant à:
former au moins une anode (410), une couche fonctionnelle de matière organique (403) et une cathode (402) sur la surface du substrat flexible (30) opposée à la surface qui a adhéré à la couche adhésive (20), dans lequel la couche fonctionnelle de matière organique (403) est située entre l'anode (401) et la cathode (402).

6. Procédé de fabrication selon la revendication 5, dans lequel un transistor à couche mince (404) est en outre formé sur la surface du substrat flexible (30) opposée à la surface qui a adhéré à la couche adhésive (20), et une électrode de drain du transistor à couche mince (404) est connecté électriquement à l'anode (401).

7. Procédé de fabrication selon la revendication 1, dans lequel,
l'étape de formation des éléments d'affichage sur la surface du substrat flexible (30) opposée à la surface qui a adhéré à la couche adhésive (20) comprend l'étape consistant à :
former au moins un transistor à couche mince (404) et une électrode de pixel (405) connectée électriquement à une électrode de drain du transistor à couche mince (404) sur la surface du substrat flexible (30) opposée à la surface qui a adhéré à la couche adhésive (20).

8. Procédé de fabrication selon la revendication 1, dans lequel l'étape de formation des éléments d'affichage sur la surface du substrat flexible (30) opposée à la surface qui a adhéré à la couche adhésive (20) comprend l'étape consistant à :
former au moins une couche de couleur et une matrice noire sur la surface du substrat flexible (30) opposée à la surface qui a adhéré à la couche adhésive (20),
dans lequel la couche de couleur comprend au moins une photorésistance rouge (4071), une photorésistance verte (4072) et une photorésistance bleue (4073).

9. Procédé de fabrication selon la revendication 7 ou 8, comprenant en outre :
l'étape supplémentaire consistant à former une électrode commune (406) sur la surface du substrat flexible (30) opposée à la surface qui a adhéré à la couche adhésive (20).

10. Procédé de fabrication selon la revendication 1, comprenant en outre :
l'étape supplémentaire consistant à former une unité d'affichage électrophorétique sur la surface du substrat flexible (30) opposée à la surface qui a adhéré à la couche adhésive (20).

11. Système comprenant une structure de substrat, utilisée pour le procédé de fabrication selon la revendication 1, la structure de substrat comprenant :
un substrat porteur (10) ;
une couche adhésive (20) formée sur le substrat porteur (10) ; et dans lequel le système comprend
un élément chauffant électromagnétique (50) disposé sur une surface du substrat porteur (10) opposée à la surface sur laquelle est formée la couche adhésive (20), dans lequel l'élément chauffant électromagnétique (50) est capable de générer un champ magnétique alternatif lorsqu'il est électrifié, dans lequel le substrat flexible (30) est fixé au substrat porteur (10) au moyen de la couche adhésive (20), et l'adhésif de la couche adhésive (20) est un adhésif dont la viscosité se dégrade après que l'adhésif a été chauffé,
dans lequel le substrat porteur (10) comprend au moins une plaque métallique (101) susceptible d'être chauffée par le champ magnétique alternatif généré par l'élément chauffant électromagnétique (50), et
dans lequel le substrat porteur (10) comprend en outre une couche de conduction thermique isolée (102) disposée sur la plaque métallique (101), dans lequel la couche de conduction thermique isolée (102) est une couche isolante qui conduit la chaleur ; et la couche adhésive (20) est formée sur la couche de conduction thermique isolée (102), et dans lequel la couche de conduction thermique isolée (102) est une couche en céramique ou une couche en verre.

12. Système selon la revendication 11, dans lequel la zone de l'élément chauffant électromagnétique (50) est supérieure ou égale à la zone du substrat porteur (10), et le substrat porteur (10) est entièrement disposé au-dessus de l'élément chauffant électromagnétique (50).

13. Système selon l'une quelconque des revendications 1 à 12, dans lequel l'adhésif comprend au moins un des adhésifs suivants : de l'adhésif silicone, de l'adhésif polyimide et de l'adhésif acrylate.
